# EUROPEAN PATENT APPLICATION

(11) **EP 4 675 360 A1**
(43) Date of publication of application: **07.01.2026**
(21) Application number: 24763534.5
(22) Date of filing: 06.02.2024
(51) Int. Cl.: G03F 7/42, H01L 21/027, H01L 21/304

(54) **SUBSTRATE TREATMENT METHOD**

(30) Priority: 27.02.2023 JP 2023028051
(71) Applicant: SCREEN Holdings Co., Ltd., Kyoto-shi, Kyoto 602-8585 (JP)
(72) Inventor: NISHIMURA, Yuta, Kyoto-shi, Kyoto 602-8585 (JP)
(74) Representative: Kilian Kilian & Partner mbB
(86) International application number: PCT/JP2024/003817
(87) International publication number: WO 2024/181050

(57) **Abstract**

Provided is a technology that can appropriately remove an organic layer on a substrate while contributing to reduction in the usage of sulfuric acid. A substrate processing method includes a holding step (S1), a first step (S3), a second step (S4), and a third step (S5). In the holding step (S1), a substrate on a main surface of which an organic layer is formed is held, the organic layer including a first cured layer, a non-cured layer, and a second cured layer. In the first step (S3), a mixed solution of sulfuric acid and aqueous hydrogen peroxide is supplied to the main surface to remove the first cured layer. In the second step (S4), the main surface is supplied, after the first step (S1), with the mixed solution mixed at a mixing ratio lower reactive than the mixed solution in the first step (S1) to remove the non-cured layer. In the third step (S5), the main surface of the substrate is supplied, after the second step (S4), with the mixed solution mixed at a mixing ratio higher reactive than the mixed solution in the second step (S4) to remove the second cured layer.

## Description

### BACKGROUND OF THE INVENTION

### Field of the Invention

The present disclosure relates to a substrate processing method.

### Description of the Background Art

Conventionally proposed is a single-wafer substrate processing apparatus that removes a resist on a substrate (e.g., Patent Document 1). In Patent Document 1, a substrate processing apparatus removes a resist by supplying a substrate with a mixed solution of sulfuric acid and aqueous hydrogen peroxide (may be hereinafter referred to as an SPM solution).

### PRIOR ART DOCUMENT

### PATENT DOCUMENT

Patent Document 1: Japanese Patent Application Laid-Open No. 2005-026489

### SUMMARY

### PROBLEM TO BE SOLVED BY THE INVENTION

A resist includes cured layers. For example, an impurity injection step of injecting impurities into a substrate forms a cured layer and a non-cured layer in a resist. The cured layer can be formed not only in a portion closer to an exposed surface of the resist (referred to as a first cured layer) but also in a portion closer to the main surface of the substrate (referred to as a second cured layer). Thus, a part of the second cured layer can be formed below the non-cured layer inside the resist. The first cured layer and the second cured layer are more resistant to removal than the non-cured layer. Conversely speaking, the non-cured layer is more susceptible to removal than the first cured layer and the second cured layer.

Always using the SPM solution mixed in a highly reactive concentration is not the best to remove a resist including the first cured layer, the non-cured layer, and the second cured layer. In particular, reduction in the usage of sulfuric acid has been sought to reduce environmental loads. There has been room for contrivance on the concentration of the SPM solution in view of reduction in the usage of sulfuric acid.

Thus, the present disclosure has an object of providing a technology that can appropriately remove an organic layer on a substrate while contributing to reduction in the usage of sulfuric acid.

### MEANS TO SOLVE THE PROBLEM

A first aspect is a substrate processing method for removing an organic layer on a substrate, the organic layer being formed on a main surface of the substrate, the organic layer including a first cured layer, a non-cured layer, and a second cured layer, the method including: a holding step of holding the substrate; a first step of supplying the main surface of the substrate with a mixed solution of sulfuric acid and aqueous hydrogen peroxide to remove the first cured layer; a second step of supplying, after the first step, the main surface of the substrate with the mixed solution mixed at a mixing ratio lower reactive than the mixed solution in the first step to remove the non-cured layer; and a third step of supplying, after the second step, the main surface of the substrate with the mixed solution mixed at a mixing ratio higher reactive than the mixed solution in the second step to remove the second cured layer.

A second aspect is the substrate processing method according to the first aspect, wherein the mixed solution is supplied to the main surface of the substrate in the form of droplets in at least one of the first step and the third step, and the mixed solution is supplied to the main surface of the substrate in the form of a continuous stream in the second step.

A third aspect is the substrate processing method according to the second aspect, and further includes a finishing SPM step of supplying, after the third step, the main surface of the substrate with the mixed solution in the form of the continuous stream, wherein the mixed solution is supplied to the main surface of the substrate in the form of droplets in the third step.

A fourth aspect is the substrate processing method according to any one of the first to third aspects, wherein a concentration of the sulfuric acid in the mixed solution in the second step is lower than a concentration of the sulfuric acid in the mixed solution in the first step.

A fifth aspect is the substrate processing method according to any one of the first to third aspects, wherein a concentration of the sulfuric acid in the mixed solution in the second step is higher than a concentration of the sulfuric acid in the first step, and in the second step, the sulfuric acid stored in a tank is supplied to the main surface of the substrate through a liquid supply pipe, and the mixed solution passing through the main surface of the substrate is returned to the tank through a recovery pipe.

### EFFECTS OF THE INVENTION

Since a highly reactive mixed solution is used in the first step and the third step, the first aspect can remove the first cured layer and the second cured layer more appropriately. In the second step, the non-cured layer softer than the first cured layer and the second cured layer is removed. Thus, the non-cured layer can be appropriately removed even with a mixed solution mixed at a low reactive mixing ratio. Moreover, since a mixing ratio different from those of the first and third steps can be employed in the second step, a mixing ratio at which the usage of sulfuric acid is reduced can be employed.

The second aspect allows the physical force of droplets to be applied to a cured layer in at least one of the first step and the third step. Thus, the cured layer can be removed more appropriately. Since a mixed solution is supplied to a substrate in the form of a continuous stream in the second step, gas for generating droplets need not be used, and running costs can be reduced.

The third aspect can suppress generation of a residue in an organic layer.

The fourth aspect can reduce the usage of sulfuric acid.

Since a mixed solution with a higher concentration of sulfuric acid is returned to a tank according to the fifth aspect, sulfuric acid can be recycled. Thus, the substantial usage of sulfuric acid can be reduced.

### BRIEF DESCRIPTION OF THE DRAWINGS

[FIG. 1] is a plan view schematically illustrating an example structure of a substrate processing apparatus.
[FIG. 2] is a cross-sectional view schematically illustrating an example structure of a part of a substrate.
[FIG. 3] is a block diagram schematically illustrating an example configuration of a controller.
[FIG. 4] is a diagram schematically illustrating an example structure of a processing part according to the first embodiment.
[FIG. 5] is a flowchart illustrating example substrate processing.
[FIG. 6] are diagrams schematically illustrating example states of the processing part in respective Steps.
[FIG. 7] is a graph illustrating example changes in a first flow rate of sulfuric acid, a second flow rate of aqueous hydrogen peroxide, and a concentration of sulfuric acid in an SPM solution over time.
[FIG. 8] are diagrams illustrating example structures of a part of a substrate W immediately after the respective Steps.
[FIG. 9] is a diagram schematically illustrating a first example structure of a processing part 1 according to the second embodiment.
[FIG. 10] are diagrams schematically illustrating example states of the processing part in the respective Steps.
[FIG. 11] is a timing chart illustrating example operations of the processing part.
[FIG. 12] is a diagram illustrating a second example structure of the processing part 1 according to the second embodiment.

### DESCRIPTION OF THE PREFERRED EMBODIMENTS

Embodiments will be described below in detail with reference to the drawings. It should be noted that dimensions and the number of components in the drawings are shown in exaggeration or in simplified form as appropriate for the sake of easier understanding. The same reference signs are allocated to parts having similar structures and functions, and overlapping description will be omitted hereinafter.

In the following description, the same reference signs are allocated to the same constituent elements, and their names and functions are the same. Therefore, detailed description of such constituent elements may be omitted to avoid redundant description.

Even when the ordinal numbers such as "first" and "second" are used in the following description, these terms are used for convenience to facilitate the understanding of the details of embodiments. The order indicated by these ordinal numbers does not restrict the details of the embodiments.

Unless otherwise noted, the expressions indicating relative or absolute positional relationships (e.g., "in one direction", "along one direction", "parallel", "orthogonal", "central", "concentric", and "coaxial") include those exactly indicating the positional relationships and those where an angle or a distance is relatively changed within tolerance or to the extent that similar functions can be obtained. Unless otherwise noted, the expressions indicating equality (e.g., "same", "equal", "uniform", and "homogeneous") include those indicating quantitatively exact equality and those in the presence of a difference within tolerance or to the extent that similar functions can be obtained. Unless otherwise noted, the expressions indicating shapes (e.g., "rectangular" or "cylindrical") include those indicating geometrically exact shapes and those indicating, for example, roughness or a chamfer to the extent that similar advantages can be obtained. An expression "comprising", "including", "containing", or "having" a certain constituent element is not an exclusive expression for excluding the presence of the other constituent elements. An expression "at least one of A, B, and C" involves "only A", "only B", "only C", "any two of A, B, and C", and "all of A, B, and C".

### <First embodiment>

### <Overall structure of substrate processing apparatus>

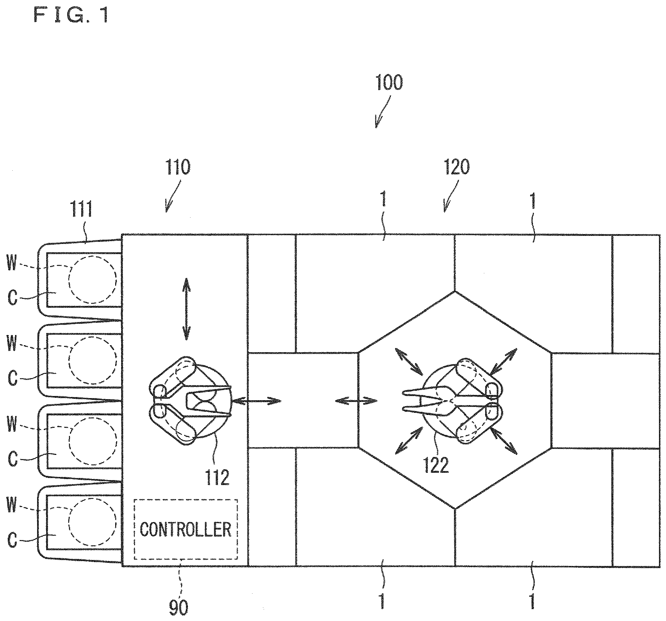

FIG. 1 is a plan view schematically illustrating an example structure of a substrate processing apparatus 100. The substrate processing apparatus 100 is a single-wafer processing apparatus that processes substrates W one by one. The substrate W is plate-shaped. The substrate W is, for example, a semiconductor substrate, and is disk-shaped. The size of the substrate W is not particularly limited, and its diameter is, for example, approximately 300 mm. The substrate W is not limited to a semiconductor substrate but various substrates are applicable to the substrate W, for example, a photomask glass substrate, a liquid crystal display glass substrate, a plasma display glass substrate, a field-emission display (FED) substrate, an optical disk substrate, a magnetic disk substrate, and a magneto-optical disk substrate. The shape of the substrate is not limited to the disk shape but may be various shapes, for example, a rectangular plate shape.

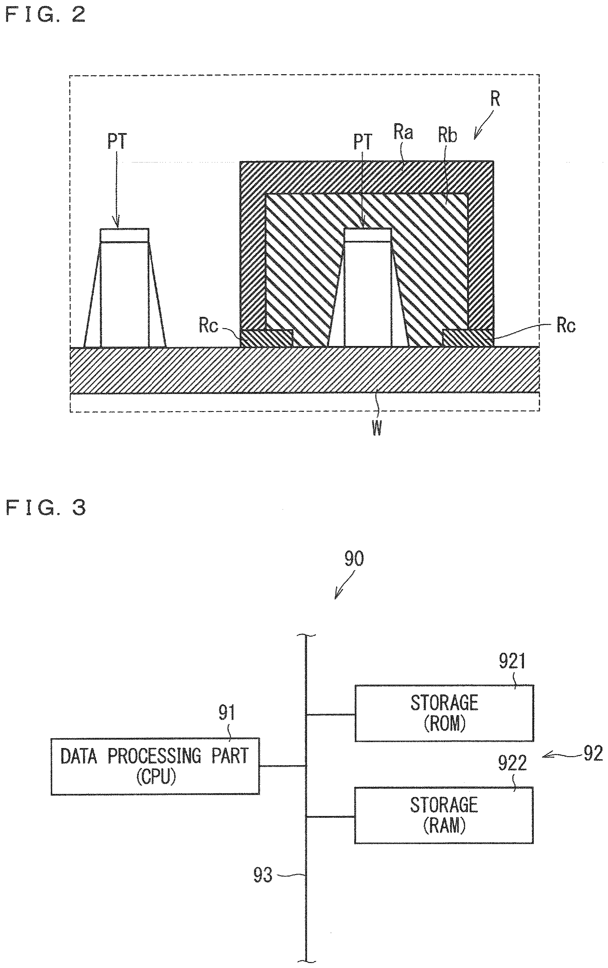

FIG. 2 is a cross-sectional view schematically illustrating an example structure of a part of the substrate W. A pattern PT and a resist layer R are formed on the main surface of the substrate W. The pattern PT is a pattern for constructing a semiconductor device, and can be formed from various layers. The resist layer R is an organic layer. In an example of FIG. 2, the resist layer R covers the one pattern PT. These pattern PT and resist layer R are formed by a resist formation apparatus (not illustrated) on the main surface of the substrate W, before being transported to the substrate processing apparatus 100.

For example, an impurity injection apparatus (not illustrated) injects impurities into the substrate W before the substrate W is transported to the substrate processing apparatus 100. In this impurity injection step, ions with high energy and high current are injected or a plasma is doped. This impurity injection step partially alters the resist layer R of the substrate W to form a first cured layer Ra, a non-cured layer Rb, and a second cured layer Rc in the resist layer R. In other words, the resist layer R includes the first cured layer Ra, the non-cured layer Rb, and the second cured layer Rc.

The first cured layer Ra is mainly a portion closer to an exposed surface of the resist layer R, and is a portion cured by the impurity injection step. In the example of FIG. 2, the non-cured layer Rb is an inner portion of the resist layer R, and is a portion hardly cured. The second cured layer Rc is a portion below the first cured layer Ra in the resist layer R, and a part of the second cured layer Rc is located immediately below the non-cured layer Rb. The second cured layer Rc is also a portion cured by the impurity injection step. In such a structure, the second cured layer Rc is located below the first cured layer Ra (closer to the substrate W), and at least a portion of an upper surface of the second cured layer Rc (a surface opposite to the substrate W) is covered with the non-cured layer Rb. Furthermore, an upper surface of the non-cured layer Rb (a surface opposite to the substrate W) is covered with the first cured layer Ra, and a side surface of the non-cured layer Rb is covered with the first cured layer Ra and the second cured layer Rc. The first cured layer Ra and the second cured layer Rc are harder and more resistant to removal than the non-cured layer Rb.

The substrate processing apparatus 100 performs an organic matter removal process for removing the resist layer R of the substrate W. In an example of FIG. 1, the substrate processing apparatus 100 includes an indexer block 110, a processing block 120, and a controller 90. The indexer block 110 is an interface part for transporting the substrate W between the processing block 120 and the outside. The processing block 120 is mainly a part that processes the substrate W received from the indexer block 110. The controller 90 is a part that has centralized control over the substrate processing apparatus 100.

### <Indexer block 110>

In the example of FIG. 1, the indexer block 110 includes a plurality of load ports 111 and an indexer robot 112. Each of the load ports 111 holds a substrate container (hereinafter referred to as a carrier C) transported from the outside. The carrier C houses a plurality of the substrates W aligned in a vertical direction. The indexer robot 112 is a transport unit that transports the substrate W between each of the carriers C and the processing block 120. The indexer robot 112 sequentially unloads, from the carriers C, the substrates W to be processed, and transports the substrates W to the processing block 120. Furthermore, the indexer robot 112 sequentially receives the substrates W processed by the processing block 120 from the processing block 120, and houses the substrates W in the carriers C. The carriers C housing the processed substrates W are transported from the load ports 111 to the outside.

### <Processing block 120>

In the example of FIG. 1, the processing block 120 includes one or more processing parts 1 and a center robot 122. In the example of FIG. 1, the processing block 120 includes a plurality of the processing parts 1. The center robot 122 is a transport unit that transports the substrate W between the indexer robot 112 and each of the processing parts 1. The center robot 122 transports, into the processing parts 1, the substrates W to be processed from the indexer robot 112, and transports, from the processing parts 1, the substrates W processed by the processing parts 1. The center robot 122 transports the substrates W to the other processing parts 1 as necessary, and then passes the substrates W to the indexer robot 112.

Each of the processing parts 1 is a single-wafer device that processes the substrates W one by one. An example specific structure of the processing part 1 will be described later in detail.

### <Controller 90>

The controller 90 has centralized control over the substrate processing apparatus 100. Specifically, the controller 90 controls the indexer robot 112, the center robot 122, and the processing parts 1. FIG. 3 is a block diagram schematically illustrating an example configuration of the controller 90. The controller 90 is an electronic circuit, and includes, for example, a data processing part 91 and a storage 92. In a specific example of FIG. 3, the data processing part 91 and the storage 92 are mutually connected through a bus 93. The data processing part 91 may be, for example, an arithmetic processing unit such as a central processing unit (CPU). The storage 92 may include a non-transitory storage (e.g., a read-only memory (ROM) or hard disk) 921 and a transitory storage (e.g., a random-access memory (RAM)) 922. The non-transitory storage 921 may store, for example, a program for defining processes to be executed by the controller 90. The data processing part 91 executes this program, so that the controller 90 can execute the processes defined in the program. Obviously, hardware such as a dedicated logic circuit may execute a part or all the processes to be executed by the controller 90.

### <Processing part>

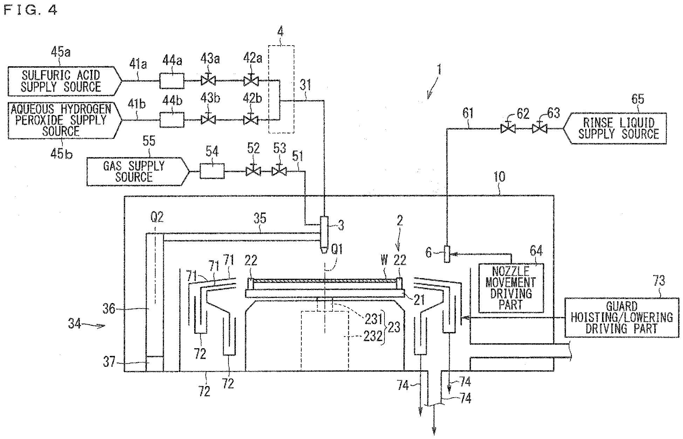

FIG. 4 is a diagram schematically illustrating an example structure of the processing part 1 according to the first embodiment. All the processing parts 1 belonging to the substrate processing apparatus 100 need not have the structure exemplified in FIG. 4. At least one of the processing parts 1 of the substrate processing apparatus 100 should have the structure exemplified in FIG. 4.

The processing part 1 performs the organic matter removal process on the substrate W by supplying the main surface of the substrate W with a mixed solution of sulfuric acid and aqueous hydrogen peroxide (hereinafter referred to as an SPM solution). Here, the resist layer R that is an example organic layer is formed on the main surface of the substrate W. As illustrated in FIG. 4, the processing part 1 includes a substrate holder 2 and a first nozzle 3.

In an example of FIG. 4, the processing part 1 also includes a chamber 10. The chamber 10 is box-shaped. The internal space of the chamber 10 corresponds to a processing space in which the substrate W is processed. The chamber 10 is provided with an openable and closable transport entrance (not illustrated). The center robot 122 transports, into the chamber 10, the substrates W to be processed through the transport entrance, and transports, from the chamber 10, the processed substrates W through the transport entrance. The substrates W are transported into the chamber 10, for example, in an orientation in which the main surface including the resist layer R faces vertically upward. In other words, the main surface of the substrate W in which the resist layer R is formed is the upper surface.

The substrate holder 2 is provided within the chamber 10. The center robot 122 passes the substrate W to the substrate holder 2. The substrate holder 2 rotates the substrate W about a rotation axis line Q1 while holding the substrate W in a horizontal orientation. The horizontal orientation is an orientation such that a thickness direction of the substrate W is along the vertical direction. The rotation axis line Q1 is an axis line that passes through the center of the substrate W and extends along the vertical direction. The substrate holder 2 can be referred to as a spin chuck. Here, the substrate holder 2 holds the substrate W in the orientation in which the main surface including the resist layer R faces vertically upward.

In the example of FIG. 4, the substrate holder 2 includes a spin base 21, a plurality of chuck pins 22, and a rotation driving part 23. The spin base 21 is plate-shaped (e.g., disk-shaped), and is provided in an orientation in which the thickness direction of the spin base 21 is along the vertical direction.

The chuck pins 22 are arranged on the upper surface of the spin base 21. The chuck pins 22 are arranged, for example, at regular intervals along a circumferential direction of the rotation axis line Q1. Each of the chuck pins 22 is arranged displaceable between a holding position and a release position which will be described next. The holding position is a position at which the chuck pin 22 abuts the outer edge of the substrate W. The chuck pins 22 are stopped at the respective holding positions to hold the substrate W. FIG. 4 illustrates the chuck pins 22 stopped at the holding positions. The release position is a position at which each of the chuck pins 22 is away from the substrate W. The chuck pins 22 are stopped at the respective release positions to release hold of the substrate W. The substrate holder 2 also includes a pin driving part (not illustrated) that displaces the chuck pins 22. The pin driving part includes a driving source, for example, a motor or an air cylinder, and is controlled by the controller 90.

The rotation driving part 23 includes a shaft 231 and a motor 232. An upper end of the shaft 231 is connected to a lower surface of the spin base 21. The shaft 231 extends along the rotation axis line Q1 from the lower surface of the spin base 21. The controller 90 controls the motor 232 to rotate the shaft 231 about the rotation axis line Q1. This rotates the spin base 21, the chuck pins 22, and the substrate W in unison about the rotation axis line Q1.

The substrate holder 2 need not always include the chuck pins 22. For example, the substrate holder 2 may hold the substrate W in a chucking method such as a vacuum chuck, an electrostatic chuck, and a Bernoulli chuck.

The first nozzle 3 is disposed, in the chamber 10, vertically above the substrate W held by the substrate holder 2. The first nozzle 3 discharges a processing liquid toward the main surface of the substrate W held by the substrate holder 2. In the example of FIG. 4, the first nozzle 3 can discharge the SPM solution that is a mixture of sulfuric acid and aqueous hydrogen peroxide as a processing liquid.

Each of the processing parts 1 allows the first nozzle 3 to discharge the SPM solution in a variable concentration. In the example of FIG. 4, the first nozzle 3 is connected to a downstream end of a liquid supply pipe 31, and an upstream end of the liquid supply pipe 31 is connected to a mixing part 4. The mixing part 4 is also connected to a first liquid supply pipe 41a and a second liquid supply pipe 41b. Sulfuric acid flows into the mixing part 4 through the first liquid supply pipe 41a, and carbon dioxide water flows into the mixing part 4 through the second liquid supply pipe 41b. This allows the mixing part 4 to mix sulfuric acid and aqueous hydrogen peroxide. The mixing part 4 supplies the liquid supply pipe 31 with the SPM solution that is a mixture of sulfuric acid and aqueous hydrogen peroxide. In the example of FIG. 4, the liquid supply pipe 31, the first liquid supply pipe 41a, and the second liquid supply pipe 41b are connected to each other, and its connecting part functions as the mixing part 4.

A first supply valve 42a and a first flow rate regulating valve 43a are inserted into the first liquid supply pipe 41a. Furthermore, an upstream end of the first liquid supply pipe 41a is connected to a sulfuric acid supply source 45a. Opening the first supply valve 42a allows sulfuric acid to be supplied from the sulfuric acid supply source 45a to the liquid supply pipe 31 through the first liquid supply pipe 41a. The first flow rate regulating valve 43a regulates a first flow rate of sulfuric acid flowing through the first liquid supply pipe 41a. The controller 90 controls the first supply valve 42a and the first flow rate regulating valve 43a. In the example of FIG. 4, a first flow rate sensor 44a is also disposed in the first liquid supply pipe 41a. The first flow rate sensor 44a measures the first flow rate of sulfuric acid flowing through the first liquid supply pipe 41a. The first flow rate regulating valve 43a regulates the first flow rate of sulfuric acid flowing through the first liquid supply pipe 41a, based on a measurement result of the first flow rate sensor 44a. A pair of the first flow rate regulating valve 43a and the first flow rate sensor 44a may be a massflow controller.

A second supply valve 42b and a second flow rate regulating valve 43b are inserted into the second liquid supply pipe 41b. Furthermore, an upstream end of the second liquid supply pipe 41b is connected to an aqueous hydrogen peroxide supply source 45b. Opening the second supply valve 42b allows aqueous hydrogen peroxide to be supplied from the aqueous hydrogen peroxide supply source 45b to the liquid supply pipe 31 through the second liquid supply pipe 41b. The second flow rate regulating valve 43b regulates a second flow rate of aqueous hydrogen peroxide flowing through the second liquid supply pipe 41b. The controller 90 controls the second supply valve 42b and the second flow rate regulating valve 43b. In the example of FIG. 4, a second flow rate sensor 44b is also disposed in the second liquid supply pipe 41b. The second flow rate sensor 44b measures the second flow rate of aqueous hydrogen peroxide flowing through the second liquid supply pipe 41b. The second flow rate regulating valve 43b regulates the second flow rate of aqueous hydrogen peroxide flowing through the second liquid supply pipe 41b, based on a measurement result of the second flow rate sensor 44b. A pair of the second flow rate regulating valve 43b and the second flow rate sensor 44b may be a massflow controller.

In such a structure, the SPM solution mixed at a mixing ratio corresponding to the first flow rate of sulfuric acid and the second flow rate of aqueous hydrogen peroxide flows through the liquid supply pipe 31. The SPM solution is supplied to the first nozzle 3 through the liquid supply pipe 31, and is discharged from the first nozzle 3.

A heater (not illustrated) may be disposed in the first liquid supply pipe 41a. The heater heats the sulfuric acid flowing through the first liquid supply pipe 41a to increase the temperature of the sulfuric acid to a temperature appropriate for processing. The heater may regulate the temperature of the sulfuric acid, for example, to a temperature higher than the room temperature and in a range lower than or equal to 170 degrees centigrade. The controller 90 controls the heater. The heater may be, for example, an electrical resistance heater with a heating wire.

In the example of FIG. 4, the first nozzle 3 is a spray nozzle. The first nozzle 3 is, for example, a two-fluid nozzle. The first nozzle 3 may be an internal mix type spray nozzle or an external mix type spray nozzle.

The type of the first nozzle 3 is not particularly limited. The first nozzle 3 may be, for example, a straight nozzle that discharges the SPM solution from a single outlet in the form of a continuous stream. Alternatively, the first nozzle 3 may be a shower nozzle that discharges the SPM solution from a plurality of outlets in the form of continuous streams. Alternatively, the first nozzle 3 may be a steam nozzle that discharges vapors of the SPM solution. In this case, the sulfuric acid supply source 45a supplies vapors of sulfuric acid to the first liquid supply pipe 41a, and the aqueous hydrogen peroxide supply source 45b supplies vapors of aqueous hydrogen peroxide to the second liquid supply pipe 41b. Herein, the first nozzle 3 is a spray nozzle as one example.

In the example of FIG. 4, the first nozzle 3 is also connected to a downstream end of an gas supply pipe 51, and an upstream end of the gas supply pipe 51 is connected to a gas supply source 55. A gas valve 52 and a flow rate regulating valve 53 are inserted into the gas supply pipe 51. Opening the gas valve 52 allows inert gas at a high pressure from the gas supply source 55 to be supplied to the first nozzle 3 through the gas supply pipe 51. The inert gas supplied to the first nozzle 3 is mixed with the SPM solution, so that a state of the SPM solution is changed into a droplet state. Consequently, the first nozzle 3 discharges the SPM solution in the form of droplets. On the other hand, closing the gas valve 52 stops supply of the inert gas to the first nozzle 3. The flow rate regulating valve 53 regulates a flow rate of the inert gas flowing through the gas supply pipe 51. The controller 90 controls the gas valve 52 and the flow rate regulating valve 53. In the example of FIG. 4, a flow rate sensor 54 is also disposed in the gas supply pipe 51. The flow rate sensor 54 measures the flow rate of the inert gas flowing through the gas supply pipe 51. The flow rate regulating valve 53 regulates the flow rate of the aqueous hydrogen peroxide flowing through the gas supply pipe 51, based on a measurement result of the flow rate sensor 54. A pair of the flow rate regulating valve 53 and the flow rate sensor 54 may be a massflow controller. Inert gas contains, for example, at least one of nitrogen gas and noble gas (e.g., argon gas).

In the example of FIG. 4, the processing part 1 also includes a nozzle movement driving part 34. The nozzle movement driving part 34 is controlled by the controller 90, and moves the first nozzle 3 in the chamber 10. Specifically, the nozzle movement driving part 34 moves the first nozzle 3 between a first processing position and a first wait position which will be described next. The first processing position is a position at which the first nozzle 3 discharges the SPM solution toward the main surface of the substrate W held by the substrate holder 2, and is a position at which the first nozzle 3 faces the main surface of the substrate W in the vertical direction. In the example of FIG. 4, the first nozzle 3 stopped at the first processing position is illustrated. The first wait position is a position at which the first nozzle 3 does not discharge the SPM solution toward the main surface of the substrate W held by the substrate holder 2, and is, for example, a position outward of the substrate W in a radial direction.

In the example of FIG. 4, the nozzle movement driving part 34 includes an arm 35, a support column 36, and a rotation driving part 37. The support column 36 has a columnar shape extending along the vertical direction, and is disposed outward of guards 71 to be described later, in the radial direction in a plan view. The arm 35 has a rod shape extending along a horizontal direction, has a base end connected to the support column 36, and has a tip connected to the first nozzle 3. The rotation driving part 37 includes a motor (not illustrated) controlled by the controller 90, and rotates the support column 36 about a center axis line Q2 in a predetermined angle range in forward and reverse directions. This makes the first nozzle 3 reciprocate along a circumferential direction of the center axis line Q2. The support column 36 is disposed such that the first processing position and the first wait position are located on a movement trajectory of the first nozzle 3. The nozzle movement driving part 34 need not always have the aforementioned structure, and may include a linear driving part, for example, a ball screw mechanism or a linear motor.

Once the first nozzle 3 discharges the SPM solution toward the main surface of the rotating substrate W with the first nozzle 3 being located in the first processing position, the SPM solution is supplied to the main surface of the substrate W. The SPM solution sit on the main surface of the substrate W flows outward in the radial direction with rotation of the substrate W, and flies off outward from the outer edge of the substrate W. Here, sulfuric acid and aqueous hydrogen peroxide in the SPM solution react each other to generate an active ingredient with a higher oxidation potential (e.g., Caro's acid). The SPM solution can remove the resist layer R mainly by reaction of the active ingredient with the resist layer R.

In the example of FIG. 4, the processing part 1 also includes a second nozzle 6. The second nozzle 6 is disposed, in the chamber 10, vertically above the substrate W held by the substrate holder 2. The second nozzle 6 discharges a rinse liquid toward the main surface of the substrate W held by the substrate holder 2. The type of the second nozzle 6 is not particularly limited. The second nozzle 6 may be, for example, a straight nozzle with a single outlet that discharges the rinse liquid in the form of a continuous stream.

The second nozzle 6 is connected to a downstream end of a liquid supply pipe 61, and an upstream end of the liquid supply pipe 61 is connected to a rinse liquid supply source 65. The rinse liquid is, for example, pure water (i.e., deionized water). A supply valve 62 and a flow rate regulating valve 63 are inserted into the liquid supply pipe 61. Opening the supply valve 62 allows the second nozzle 6 to discharge the rinse liquid. Closing the supply valve 62 stops discharging the rinse liquid from the second nozzle 6. The flow rate regulating valve 63 regulates a flow rate of the rinse liquid flowing through the liquid supply pipe 61. The flow rate regulating valve 63 may be a massflow controller. The controller 90 controls the supply valve 62 and the flow rate regulating valve 63.

In the example of FIG. 4, the processing part 1 also includes a nozzle movement driving part 64. The nozzle movement driving part 64 is controlled by the controller 90, and moves the second nozzle 6 between a second processing position and a second wait position which will be described next. The second processing position is a position at which the second nozzle 6 discharges the rinse liquid toward the main surface of the substrate W held by the substrate holder 2, and is, for example, a position at which the second nozzle 6 faces a center portion of the main surface of the substrate W in the vertical direction. The second wait position is a position at which the second nozzle 6 does not discharge the rinse liquid toward the main surface of the substrate W held by the substrate holder 2, and is, for example, a position outward of the substrate W in the radial direction. FIG. 4 illustrates the second nozzle 6 stopped at the second wait position. An example specific structure of the nozzle movement driving part 64 is identical to the structure of the nozzle movement driving part 34.

Once the second nozzle 6 discharges the rinse liquid toward the main surface of the rotating substrate W with the second nozzle 6 being located in the second processing position, the rinse liquid sits on the main surface of the substrate W. The rinse liquid sit on the main surface of the substrate W flows outward in the radial direction with rotation of the substrate W, and flies off outward from the outer edge of the substrate W. Since the rinse liquid allows the SPM solution on the main surface of the substrate W to flush outward in the radial direction, the SPM solution on the main surface of the substrate W can be replaced with the rinse liquid.

In the example of FIG. 4, the processing part 1 also includes the guards 71 and a guard hoisting/lowering driving part 73. In the example of FIG. 4, the plurality of (specifically, three) guards 71 are provided. Each of the guards 71 has a cylindrical shape that surrounds the substrate W held by the substrate holder 2. The guards 71 are concentrically arranged. The guard hoisting/lowering driving part 73 is controlled by the controller 90, and hoists or lowers each of the guards 71 between an upper position and a lower position which will be described next. The upper position is a position at which an upper end of the guard 71 is vertically located above the substrate W held by the substrate holder 2. The lower position is a position at which the upper end of the guard 71 is vertically located below the upper position, and is a position at which the upper end is vertically located below the upper surface of the spin base 21. The guard hoisting/lowering driving part 73 includes, for example, a ball screw mechanism or an air cylinder.

While all the guards 71 are located in the respective upper positions, the processing liquid flown off from the outer edge of the substrate W is received by the inner circumferential surface of the inner guard 71. While the outer guard 71 and the middle guard 71 are located in the respective upper positions and the inner guard 71 is located in the lower position, the processing liquid flown off from the outer edge of the substrate W is received by the inner circumferential surface of the middle guard 71. While only the outer guard 71 is located in the upper position, the processing liquid flown off from the outer edge of the substrate W is received by the inner circumferential surface of the outer guard 71.

In the example of FIG. 4, an annular cup 72 is provided to correspond to each of the guards 71. The processing liquid flowing down the inner circumferential surface of each of the guards 71 is received by the corresponding cup 72. The processing liquid received by each of the cups 72 is discharged to the outside of the chamber 10 through a pipe 74.

The processing part 1 may include a heating part (not illustrated) that heats the substrate W held by the substrate holder 2. The heating part may be, for example, an electrical resistance heater with a heating wire. This heater can be provided between the substrate W and the spin base 21. Alternatively, the heating part may include a nozzle that discharges a heating medium at a high temperature (e.g., warm water or high-temperature inert gas) toward the main surface (e.g., the lower surface) of the substrate W.

### <First example substrate processing>

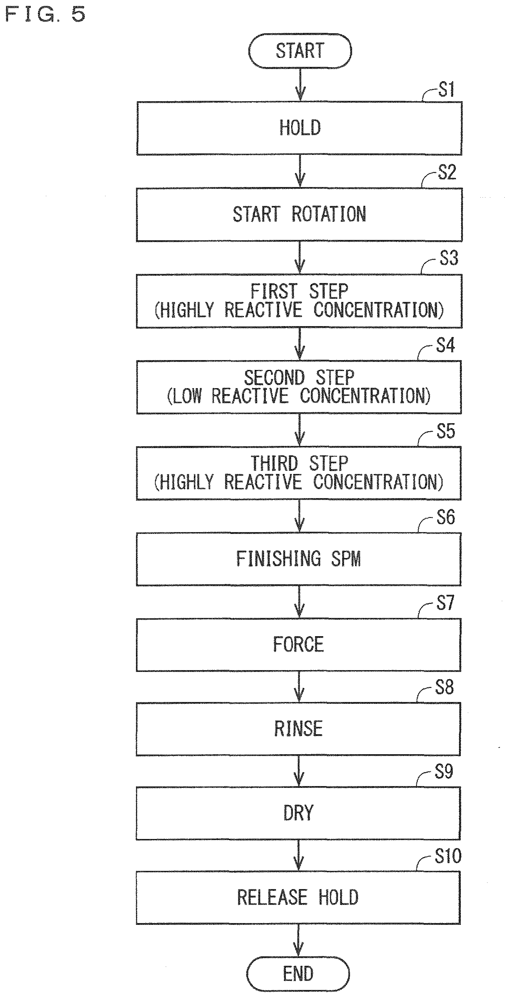

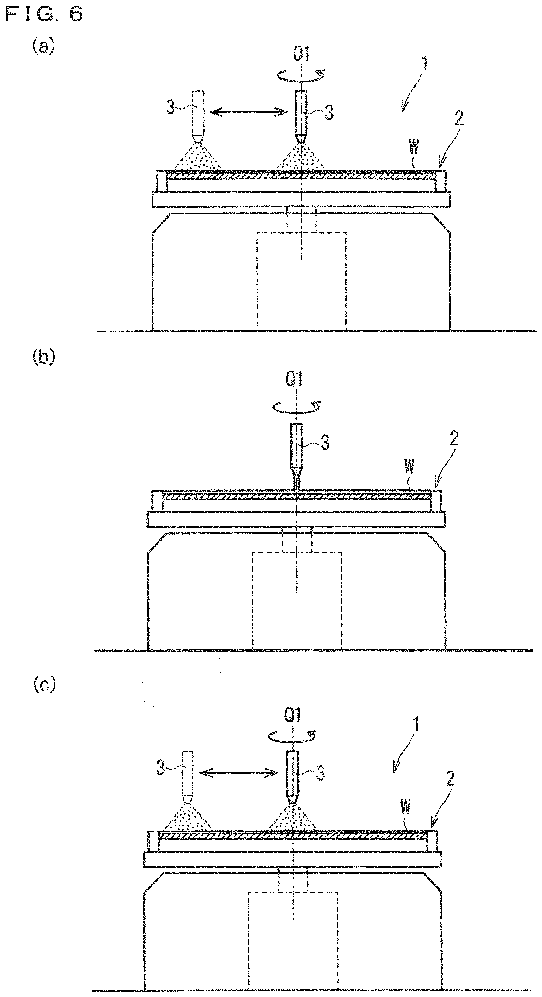

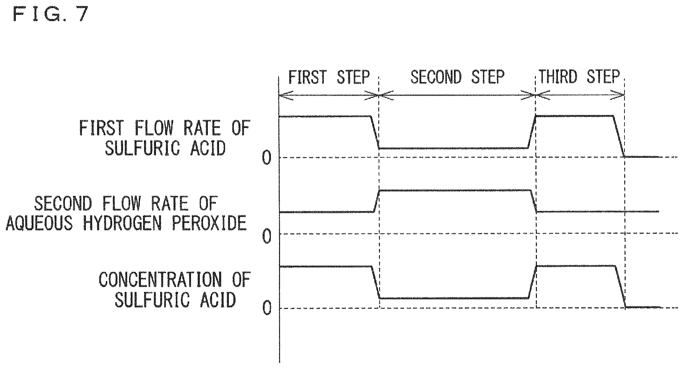

FIG. 5 is a flowchart illustrating example substrate processing. The controller 90 causes the substrate processing apparatus 100 to execute processes from Step S1 to Step S8 in accordance with a preset processing procedure (a recipe). FIG. 6 are diagrams schematically illustrating example states of the processing part 1 in Steps S3, S4, and S5 to be described later. FIG. 7 is a graph illustrating example changes in the first flow rate of sulfuric acid, the second flow rate of aqueous hydrogen peroxide, and a concentration of sulfuric acid in the SPM solution over time.

First, the center robot 122 transports the substrate W into the chamber 10 of the processing part 1. Then, the substrate holder 2 receives and holds the substrate W (Step S1: a holding step). As a specific example, the substrate holder 2 displaces the chuck pins 22 from the respective release positions to the respective holding positions. Thereby, the chuck pins 22 hold the substrate W. The substrate holder 2 continues to hold the substrate W by the end of the processing on the substrate W. For example, the resist layer R is formed on the main surface (the upper surface herein) of the substrate W.

Next, the substrate holder 2 starts to rotate the substrate W about the rotation axis line Q1 (Step S2: a rotation start step). The substrate holder 2 may maintain rotation of the substrate W by the end of the processing on the substrate W. After Step S1, the guard hoisting/lowering driving part 73 raises the guards 71 to the upper positions as appropriate.

Next, the processing part 1 supplies the main surface of the substrate W with the SPM solution (Step S3: a first step). Specifically, the processing part 1 causes the first nozzle 3 to discharge the SPM solution toward the main surface of the rotating substrate W. More specifically, first, the nozzle movement driving part 34 moves the first nozzle 3 to the first processing position. Then, the controller 90 opens the first supply valve 42a, the second supply valve 42b, and the gas valve 52. When the first supply valve 42a and the second supply valve 42b are opened, sulfuric acid flows from the sulfuric acid supply source 45a into the liquid supply pipe 31 through the first liquid supply pipe 41a, and aqueous hydrogen peroxide flows from the aqueous hydrogen peroxide supply source 45b into the liquid supply pipe 31 through the second liquid supply pipe 41b. This mixes sulfuric acid and aqueous hydrogen peroxide, so that the SPM solution that is a mixed solution thereof is supplied to the first nozzle 3 through the liquid supply pipe 31. Furthermore, opening the gas valve 52 allows the inert gas at a high pressure from the gas supply source 55 to be supplied to the first nozzle 3 through the gas supply pipe 51. This allows the first nozzle 3 to discharge the SPM solution in the form of droplets (e.g., a sprayed SPM solution) toward the main surface of the substrate W (see also FIG. 6 (a)).

The nozzle movement driving part 34 may make the first nozzle 3 reciprocate in a direction extending along the main surface of the substrate W (a horizontal direction herein). The nozzle movement driving part 34 may make the first nozzle 3 reciprocate, for example, between a center position at which the first nozzle 3 faces the center portion of the main surface of the substrate W and an outer edge position at which the first nozzle 3 faces the outer edge of the main surface of the substrate W. In an example of FIG. 6 (a), the first nozzle 3 at the center position is illustrated by solid lines, and the first nozzle 3 at the outer edge position is illustrated by virtual lines. This allows the processing part 1 to supply the SPM solution more uniformly to the entirety of the main surface of the substrate W.

The SPM solution on the main surface of the substrate W flows outward in the radial direction by centrifugal force from rotation, and flies off outward from the outer edge of the substrate W. The SPM solution flown off from the outer edge of the substrate W is received by the inner circumferential surfaces of the guards 71, and is discharged to the outside of the chamber 10 through the cups 72 and the pipes 74. This point applies to each Step to be described later.

In Step S3, the processing part 1 supplies the main surface of the substrate W with the SPM solution mixed at a highly reactive mixing ratio (= the first flow rate/the second flow rate) (see also FIG. 7). A ratio of a concentration of sulfuric acid to a concentration of hydrogen peroxide in the SPM solution is, for example, 1/3 or higher and 4 or lower, specifically 2 (i.e., sulfuric acid to aqueous hydrogen peroxide = 2:1). The controller 90 controls the first flow rate regulating valve 43a and the second flow rate regulating valve 43b such that the ratio approximates a value in the aforementioned range. Here, being "highly reactive" means that the amount of an active ingredient to be generated per unit time in the SPM solution is large. In other words, in Step S3, the processing part 1 supplies the main surface of the substrate W with the SPM solution mixed at a mixing ratio in which the amount of the active ingredient to be generated per unit time is large.

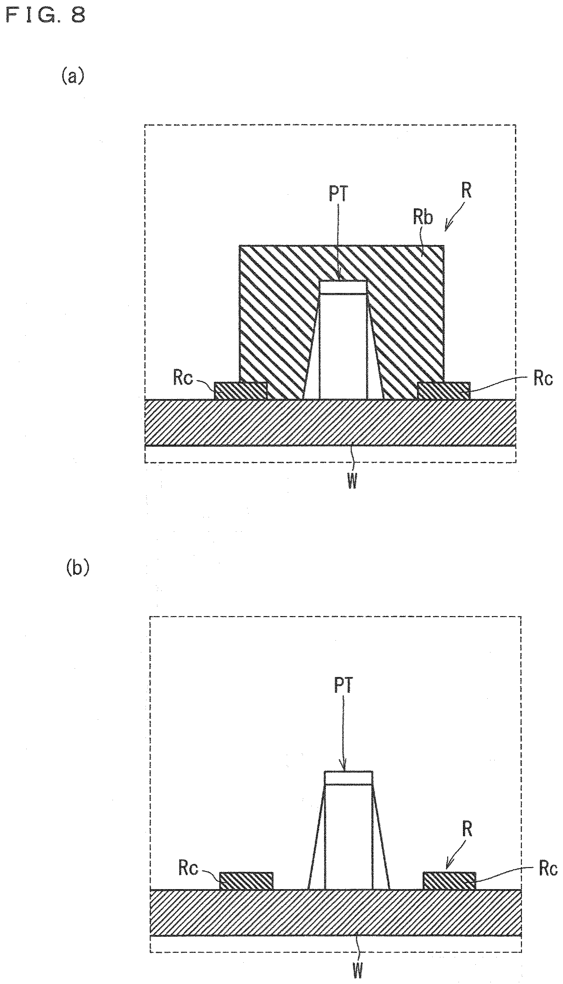

FIG. 8 are diagrams illustrating example structures of a part of the substrate W immediately after Steps S3 and S4 to be described later. As illustrated in FIG. 8 (a), Step S3 removes mainly the first cured layer Ra in the resist layer R by the SPM solution. This is because the SPM solution is apt to act on the first cured layer Ra closer to the surface of the resist layer R. In other words, the active ingredient in the SPM solution mainly reacts with the first cured layer Ra. Since an active ingredient is generated more in Step S3, the more active ingredient can react with the first cured layer Ra. Thus, the processing part 1 can remove the first cured layer Ra more appropriately. In other words, although the first cured layer Ra is relatively hard, the first cured layer Ra reacts with the more active ingredient. Thus, the first cured layer Ra can be removed more appropriately.

In Step S3, although the SPM solution can act on a portion of the second cured layer Rc which protrudes outward with respect to the non-cured layer Rb, the SPM solution resists acting on the portion when compared to the first cured layer Ra. This is because when impurities are injected, the impurities and a resist are bound to an underlayer (e.g., a silicon layer) of the substrate W. This makes the second cured layer Rc harder than the first cured layer Ra. Thus, the SPM solution resists acting on the second cured layer Rc when compared to the first cured layer Ra, and the second cured layer Rc is more resistant to removal. Consequently, the portion of the second cured layer Rc which protrudes outward with respect to the non-cured layer Rb also remains in the example of FIG. 8 (a). Since the second cured layer Rc is located in a lower portion of the resist layer R, the SPM solution is prone to stay in the second cured layer Rc, and a new SPM solution can resist acting on the second cured layer Rc. This can be a contributing factor of the remaining second cured layer Rc.

In the aforementioned example, the first nozzle 3 discharges the SPM solution in the form of droplets in Step S3. Thus, a plurality of droplets of the SPM solution collide with a liquid layer of the SPM solution on the main surface of the substrate W. This collision force (may be referred to as a physical force) is transferred to the resist layer R. As such, the physical force acting on the first cured layer Ra of the resist layer R on the main surface of the substrate W can promote exfoliation of the first cured layer Ra from the main surface of the substrate W. Thus, the processing part 1 can remove the first cured layer Ra more efficiently.

After a lapse of a first predetermined time since start of Step S3, the processing part 1 ends Step S3. The controller 90 can measure the elapsed time using, for example, a timer circuit (not illustrated). The first predetermined time is preset longer than or equal to the time required for removing the first cured layer Ra, and is stored in, for example, the storage 921. The first predetermined time can be set longer as the thickness of the first cured layer Ra is greater. In Step S3, a portion of the non-cured layer Rb and a portion of the second cured layer Rc may be removed. Conversely speaking, the first predetermined time can be set to a time to the extent that most of the non-cured layer Rb and most of the second cured layer Rc remain. Thus, at the end of Step S3, the non-cured layer Rb and the second cured layer Rc of the resist layer R are exposed.

Next, the processing part 1 supplies the main surface of the substrate W with the SPM solution mixed at a mixing ratio lower reactive than the SPM solution in Step S3 (Step S4: a second step). For example, the concentration of sulfuric acid in the SPM solution in Step S4 is lower than that in Step S3 (see also FIG. 7). As a specific example, a ratio of a concentration of sulfuric acid to a concentration of hydrogen peroxide in the SPM solution is 1/4 or higher and 1/3 or lower. In other words, the controller 90 controls the first flow rate regulating valve 43a and the second flow rate regulating valve 43b such that the ratio approximates a value in the aforementioned range. As a specific example, the controller 90 may reduce the first flow rate of sulfuric acid and increase the second flow rate of aqueous hydrogen peroxide. This can reduce the concentration of sulfuric acid in the SPM solution.

For example, the controller 90 closes the gas valve 52 in Step S4. Closing the gas valve 52 allows the first nozzle 3 to discharge the SPM solution in the form of a continuous stream. The nozzle movement driving part 34 may make the first nozzle 3 reciprocate between the center position and the outer edge position, or stop the first nozzle 3 at the center position. In the latter case, the SPM solution discharged from the first nozzle 3 sits on the center portion of the main surface of the rotating substrate W, and flows outward of the main surface of the substrate W in the radial direction by centrifugal force from rotation of the substrate W (see also FIG. 6 (b)). This allows the SPM solution to be supplied to the entirety of the main surface of the substrate W.

As illustrated in FIG. 8 (b), Step S4 removes mainly the non-cured layer Rb in the resist layer R by the SPM solution. This is for the following reason. Specifically, while the SPM solution is in contact with the non-cured layer Rb and the second cured layer Rc in the resist layer R, the amount of the active ingredient to be generated per unit time in the SPM solution is less in Step S4. Thus, the second cured layer Rc cannot be removed much, and the non-cured layer Rb is mainly removed. Furthermore, since a portion of the second cured layer Rc is located immediately below the non-cured layer Rb, the SPM solution hardly acts on this portion until the non-cured layer Rb is removed. Thus, the portion of the second cured layer Rc which is located immediately below the non-cured layer Rb remains.

Since the concentration of sulfuric acid in the SPM solution in Step S4 is low in the aforementioned example, the usage of sulfuric acid (i.e., a waste volume) can be reduced.

In the aforementioned example, the first nozzle 3 discharges the SPM solution in the form of a continuous stream in Step S4. Although the physical force of droplets does not act on the non-cured layer Rb, even such SPM solution can remove the soft non-cured layer Rb. Furthermore, the usage of inert gas can be reduced, and running costs can be reduced.

After a lapse of a second predetermined time since start of Step S4, the processing part 1 ends Step S4. The second predetermined time is preset, and is stored in, for example, the storage 921. The second predetermined time may be set, for example, longer than or equal to the time required for removing the non-cured layer Rb. The non-cured layer Rb may remain on the main surface of the substrate W at the end of Step S4. This is because this non-cured layer Rb is to be removed in Step S5 next. Conversely, the portion of the second cured layer Rc which is located immediately below the non-cured layer Rb may be removed in Step S4. In other words, the second predetermined time may be set to a time to the extent that the non-cured layer Rb and the portion of the second cured layer Rc are removed, or set to a time to the extent that a portion of the non-cured layer Rb remains. The second predetermined time can be set longer as the thickness of the non-cured layer Rb is greater.

Next, the processing part 1 supplies the main surface of the substrate W with the SPM solution mixed at a mixing ratio higher reactive than the SPM solution in Step S4 (Step S5: a third step). For example, the concentration of sulfuric acid in the SPM solution in Step S5 is higher than that in Step S4. The concentration of sulfuric acid is identical to, for example, that in Step S3. As a specific example, the controller 90 may increase the first flow rate of sulfuric acid and reduce the second flow rate of aqueous hydrogen peroxide. This can increase the concentration of sulfuric acid in the SPM solution.

For example, the controller 90 opens the gas valve 52 in Step S5. Here, the first nozzle 3 discharges the SPM solution in the form of droplets. The nozzle movement driving part 34 makes the first nozzle 3 reciprocate between the center position and the outer edge position (see also FIG. 6 (c)).

In Step S5, the SPM solution is in contact with the second cured layer Rc in the resist layer R. Since an active ingredient is generated more in Step S5, the more active ingredient can react with the second cured layer Rc. Thus, the processing part 1 can remove the hard second cured layer Rc more appropriately. When the non-cured layer Rb remains at the end of Step S4, the SPM solution also removes the non-cured layer Rb.

In the aforementioned example, the first nozzle 3 discharges the SPM solution in the form of droplets. Thus, the physical force also acts on the second cured layer Rc of the resist layer R on the main surface of the substrate W. Consequently, the processing part 1 can remove the second cured layer Rc more efficiently.

After a lapse of a third predetermined time since start of Step S5, the processing part 1 ends Step S5. The third predetermined time is preset longer than or equal to the time required for removing the second cured layer Rc, and is stored in, for example, the storage 921. The third predetermined time can be set longer as the thickness of the second cured layer Rc is greater.

It is conceivable that the second cured layer Rc is not completely removed even through Step S5 and a portion of the second cured layer Rc remains as a residue in the resist layer R.

Thus, the processing part 1 supplies the main surface of the substrate W with the SPM solution in the form of a continuous stream in an example of FIG. 5 (Step S6: a finishing SPM step). Specifically, the controller 90 closes the gas valve 52. This allows the first nozzle 3 to discharge the SPM solution in the form of a continuous stream. The nozzle movement driving part 34 may make the first nozzle 3 reciprocate between the center position and the outer edge position, or stop the first nozzle 3 at the center position. In the latter case, the SPM solution discharged from the first nozzle 3 sits on the center portion of the main surface of the rotating substrate W, and flows outward of the main surface of the substrate W in the radial direction by centrifugal force from rotation of the substrate W. The concentration of sulfuric acid in the SPM solution in Step S6 may be identical to, for example, that in Step S5.

Even when a portion of the resist layer R remains on the main surface of the substrate W, Step S6 allows the processing part 1 to remove the remaining layer. In other words, the processing part 1 can suppress generation of a residue in the resist layer R.

After a lapse of a fourth predetermined time since start of Step S6, the processing part 1 ends Step S6. The fourth predetermined time is preset, and is stored in, for example, the storage 921.

In the example of FIG. 5, next, the processing part 1 supplies the main surface of the substrate W with aqueous hydrogen peroxide (Step S7: a forcing step). Specifically, the controller 90 continues to supply aqueous hydrogen peroxide to the first nozzle 3 while stopping supply of the SPM solution to the first nozzle 3, by closing the first supply valve 42a with the second supply valve 42b being opened. This allows aqueous hydrogen peroxide to force out the sulfuric acid remaining in the liquid supply pipe 31 and an internal channel of the first nozzle 3 and discharge the sulfuric acid from the first nozzle 3. Thus, the retention of the sulfuric acid inside the first nozzle 3 can be suppressed. Moreover, precipitation of a component of sulfuric acid inside the first nozzle 3 can be suppressed.

Once sulfuric acid inside the first nozzle 3 is sufficiently discharged, the processing part 1 stops supplying aqueous hydrogen peroxide. For example, after a lapse of a fifth predetermined time since start of Step S7, the controller 90 closes the second supply valve 42b. Closing the second supply valve 42b stops discharging aqueous hydrogen peroxide from the first nozzle 3. Then, the nozzle movement driving part 34 moves the first nozzle 3 to the first wait position.

Next, the processing part 1 supplies the main surface of the substrate W with the rinse liquid (Step S8: a rinsing step). First, the nozzle movement driving part 64 moves the second nozzle 6 to the second processing position. Next, the controller 90 opens the supply valve 62. This allows the second nozzle 6 to discharge the rinse liquid toward the center portion of the main surface of the rotating substrate W. The rinse liquid sits on the center portion of the main surface of the substrate W, and flows outward of the main surface of the substrate W in the radial direction with rotation of the substrate W. Thus, the rinse liquid allows aqueous hydrogen peroxide on the main surface of the substrate W to push outward in the radial direction. Consequently, a processing liquid on the main surface of the substrate W is replaced from aqueous hydrogen peroxide to the rinse liquid.

When the aqueous hydrogen peroxide on the main surface of the substrate W is sufficiently replaced with the rinse liquid, the processing part 1 stops supplying the rinse liquid. For example, after a lapse of a sixth predetermined time since start of supplying the rinse liquid, the controller 90 closes the supply valve 62. Closing the supply valve 62 stops discharging the rinse liquid from the second nozzle 6. Then, the nozzle movement driving part 64 moves the second nozzle 6 to the second wait position.

Next, the processing part 1 dries the substrate W (Step S9: a drying step). For example, the substrate holder 2 increases a rotation speed of the substrate W (i.e., spin drying). This dries the substrate W.

Once the substrate W is sufficiently dried, the processing part 1 stops rotating the substrate W. For example, after a lapse of a seventh predetermined time since an increase in the rotation speed, the substrate holder 2 stops rotating the substrate W.

Next, the substrate holder 2 releases holding the substrate W (Step S10: a hold releasing step). Specifically, the substrate holder 2 displaces the chuck pins 22 from the respective holding positions to the respective release positions. This releases hold of the substrate W. Next, the center robot 122 receives the substrate W from the substrate holder 2, and transports the substrate W out of the processing part 1.

### <Advantages>

As described above, the processing part 1 can remove the resist layer R on the main surface of the substrate W. Moreover, in Step S3 where a removal target is mainly the hard first cured layer Ra according to the substrate processing method, the processing part 1 supplies the main surface of the substrate W with the SPM solution with a highly reactive concentration. Thus, a more active ingredient can react with the first cured layer Ra, and the first cured layer Ra can be removed more appropriately.

The first predetermined time during which the SPM solution is discharged in Step S3 is preset longer than or equal to the time required for removing the first cured layer Ra in the aforementioned example. Thus, the processing part 1 can remove the first cured layer Ra more reliably in Step S3. In Step S3, a portion of the non-cured layer Rb and a portion of the second cured layer Rc can also be removed.

In Step S4 where a removal target is mainly the non-cured layer Rb, the processing part 1 supplies the main surface of the substrate W with the SPM solution with a low reactive concentration. Since the non-cured layer Rb is relatively soft, even when the amount of an active ingredient to be generated per unit time is relatively small, the processing part 1 can remove the non-cured layer Rb. Thus, a mixing ratio at which the usage of sulfuric acid is reduced can be employed in Step S4. As a specific example, the concentration of sulfuric acid in the SPM solution in Step S4 is set lower than that in Step S3. This can reduce the usage of sulfuric acid.

In the aforementioned example, the first nozzle 3 discharges the SPM solution toward the main surface of the substrate W in the form of a continuous stream in Step S4. This can reduce the usage of inert gas.

In Step S5 where a removal target is mainly the hard second cured layer Rc, the processing part 1 supplies the main surface of the substrate W with the SPM solution with a highly reactive concentration. Thus, the second cured layer Rc can be removed more appropriately.

In the aforementioned example, the first nozzle 3 discharges the SPM solution in the form of droplets toward the main surface of the substrate W in each of Steps S3 and S5. Since this allows a plurality of droplets to apply the physical force to the resist layer R, exfoliation of the resist layer R can be promoted. The first nozzle 3 need not always discharge the SPM solution in the form of droplets in both of Steps S3 and S5. The first nozzle 3 may discharge the SPM solution in the form of droplets in either one of Steps S3 and S5, whereas the first nozzle 3 may discharge the SPM solution in a continuous state in the other step.

The third predetermined time during which the SPM solution is discharged in Step S5 is preset longer than or equal to the time required for removing the second cured layer Rc. Thus, the second cured layer Rc can be removed more reliably in Step S5.

In the aforementioned example, Step S6 is executed after Step S5. This allows the processing part 1 to suppress generation of a residue in the resist layer R.

### <Second embodiment>

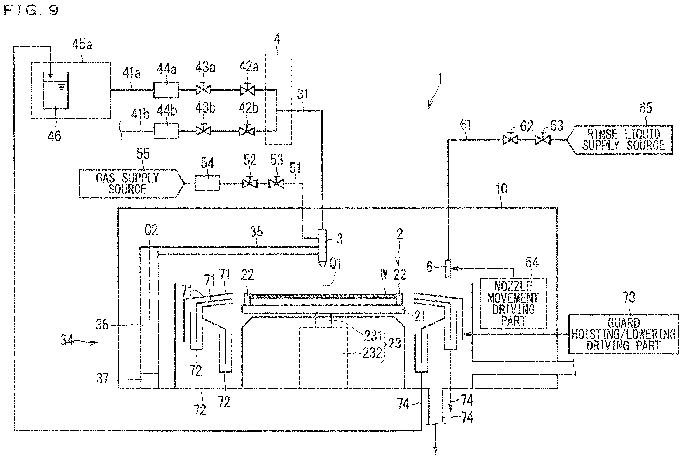

FIG. 9 is a diagram schematically illustrating a first example structure of the processing part 1 according to the second embodiment. In an example of FIG. 9, a tank 46 of the sulfuric acid supply source 45a is illustrated. The tank 46 stores sulfuric acid. For example, the upstream end of the first liquid supply pipe 41a is connected to the tank 46. The sulfuric acid in the tank 46 is supplied to the main surface of the substrate through the first liquid supply pipe 41a, the liquid supply pipe 31, and the first nozzle 3.

The sulfuric acid supply source 45a may include a circulation pipe (not illustrated) for regulating the temperature of the tank 46. An upstream end and a lower end of the circulation pipe is connected to the tank 46, and a heater (not illustrated) and a pump (not illustrated) are disposed in the circulation pipe. The temperature of the sulfuric acid in the tank 46 can be regulated to a predetermined range appropriate for processing, by heating the sulfuric acid in the circulation pipe using the heater while circulating the sulfuric acid in the tank 46 through the circulation pipe.

In the example of FIG. 9, a downstream portion of the pipe 74 connected to the cup 72 corresponding to the inner guard 71 is connected to the sulfuric acid supply source 45a. The downstream portion of this pipe 74 functions as a supply port to the tank 46. In the second embodiment, the SPM solution discharged from the first nozzle 3 to the substrate W flows outward of the main surface of the substrate W in the radial direction, flies off from the outer edge of the substrate W, and is received by the inner guard 71. The SPM solution received by the inner guard 71 is recovered by the tank 46 through the cup 72 and the pipe 74. In other words, the pipe 74 corresponding to the inner guard 71 functions as a recovery pipe that returns the SPM solution into the tank 46 in the example of FIG. 9. Downstream ends of the pipes 74 connected to the other cups 72 can be connected to an external discarding part (a factory utility).

The pipe 74 corresponding to the inner guard 71 which functions as a recovery pipe is not always limited to this. The downstream end of the pipe 74 corresponding to the outer guard 71 or the middle guard 71 may be connected to the tank 46, and this pipe 74 may function as a recovery pipe. Here, when the first nozzle 3 discharges the SPM solution, the guard 71 corresponding to the pipe 74 that functions as a recovery pipe is located in the upper position, and receives the SPM solution. The following will assume that the pipe 74 corresponding to the inner guard 71 functions as a recovery pipe.

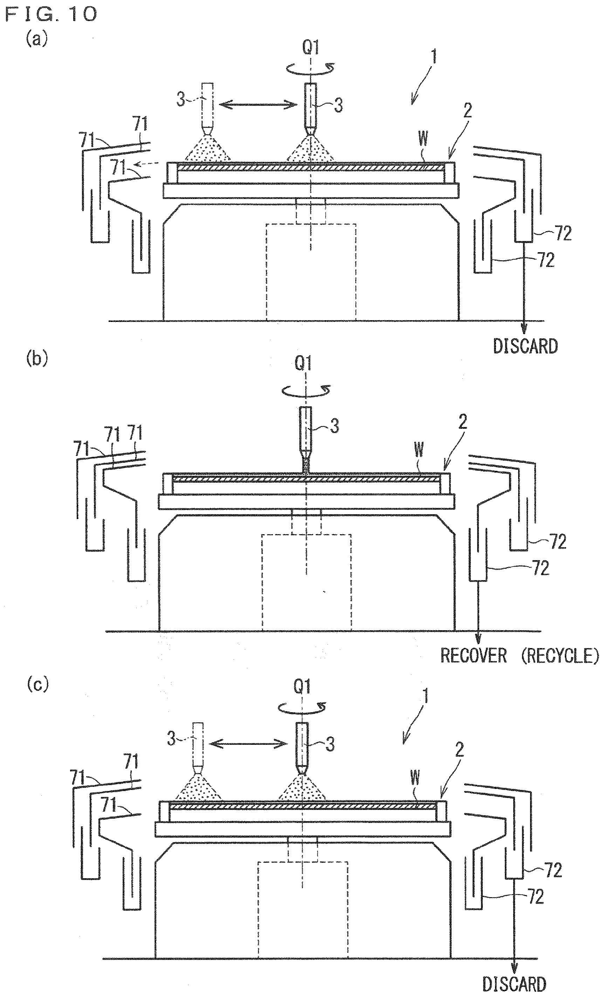

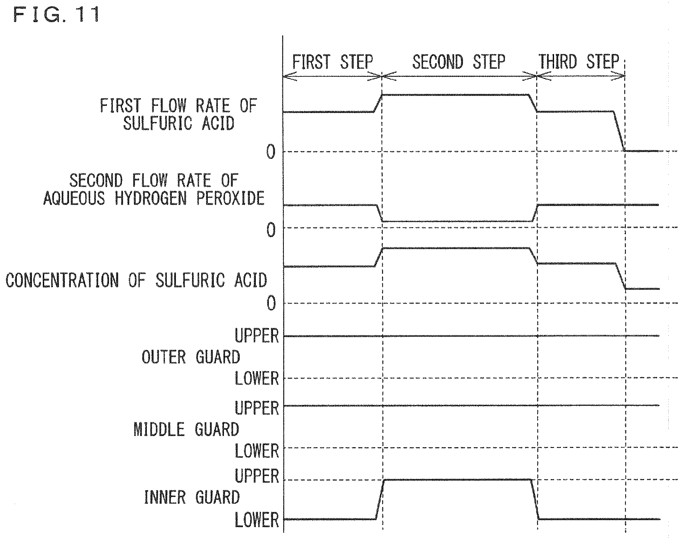

The example substrate processing according to the second embodiment is as illustrated in FIG. 5. However, specific operations in Step S3 (the first step), Step S4 (the second step), and Step S5 (the third step) can differ. FIG. 10 are diagrams schematically illustrating example states of the processing part 1 from Step S3 to Step S5. FIG. 11 is a timing chart illustrating example operations of the processing part 1.

In the second embodiment, the SPM solution supplied to the substrate W in Step S3 is discarded. As a specific example, the guard hoisting/lowering driving part 73 locates the outer guard 71 and the middle guard 71 in the upper positions and locates the inner guard 71 in the lower position in Step S3 (see FIGS. 10 and 11). This allows the SPM solution flown off from the outer edge of the substrate W in Step S3 to be received by the inner circumferential surface of the middle guard 71 and then discharged to the external discarding part through the cup 72 and the pipe 74 which correspond to the middle guard 71. In Step S3, the outer guard 71 may receive the SPM solution. In other words, the guard hoisting/lowering driving part 73 may locate the upper guard 71 in the upper position and locate also the middle guard 71 in the lower position.

When the first cured layer Ra is removed in Step S3, that is, after a lapse of the first predetermined time, the processing part 1 supplies the main surface of the substrate W with the SPM solution mixed at a mixing ratio lower reactive than the SPM solution in Step S3 (Step S4: the second step). In the second embodiment, the concentration of sulfuric acid in the SPM solution in Step S4 is higher than that in Step S3 (see FIG. 11). A ratio of a concentration of sulfuric acid to a concentration of hydrogen peroxide in the SPM solution is set to a range, for example, 4 or higher and 20 or lower, and set to, as a specific example, approximately 10 (i.e., sulfuric acid to aqueous hydrogen peroxide = 10:1). The controller 90 controls the first flow rate regulating valve 43a and the second flow rate regulating valve 43b such that the ratio approximates a value in the aforementioned range. As a specific example, the controller 90 may increase the first flow rate of sulfuric acid and reduce the second flow rate of aqueous hydrogen peroxide. This can increase the concentration of sulfuric acid.

In the second embodiment, the SPM solution supplied to the substrate W in Step S4 is recovered and recycled. As a specific example, the guard hoisting/lowering driving part 73 locates the outer guard 71, the middle guard 71, and the inner guard 71 in the upper positions in Step S4 (see FIGS. 10 and 11). This allows the SPM solution flown off from the outer edge of the substrate W in Step S4 to be received by the inner circumferential surface of the inner guard 71 and then recovered by the tank 46 through the cup 72 and the pipe 74 (a recovery pipe) which correspond to the inner guard 71.

As described above, the SPM solution with a high concentration of sulfuric acid is supplied to the substrate W, and is then recovered by the tank 46 in Step S4. Since the concentration of sulfuric acid of this SPM solution is high, even when the SPM solution is recovered by the tank 46, a decrease in the concentration of sulfuric acid in the tank 46 can be suppressed. Then, the sulfuric acid in the tank 46 is recycled for the processing on the substrate W.

When the non-cured layer Rb is removed in Step S4, that is, after a lapse of the second predetermined time, the processing part 1 supplies the main surface of the substrate W with the SPM solution mixed at a mixing ratio higher reactive than the SPM solution in Step S4 (Step S45: the third step). In the second embodiment, the concentration of sulfuric acid in the SPM solution in Step S5 is lower than that in Step S4 (see FIG. 11). A ratio of a concentration of sulfuric acid to a concentration of hydrogen peroxide in the SPM solution is identical to, for example, that in Step S3.

In the second embodiment, the SPM solution supplied to the substrate W in Step S5 is discarded. As a specific example, the guard hoisting/lowering driving part 73 locates the outer guard 71 and the middle guard 71 in the upper positions and locates the inner guard 71 in the lower position in Step S5 (see FIGS. 10 and 11). This allows the SPM solution flown off from the outer edge of the substrate W in Step S5 to be received by the inner circumferential surface of the middle guard 71 and then discharged to the discarding part through the cup 72 and the pipe 74 which correspond to the middle guard 71.

When the second cured layer Rc is removed in Step S5, that is, after a lapse of the third predetermined time, the processing part 1 ends Step S5 and executes Steps S6 to S10 in this order, similarly to the first embodiment.

As described above, the substrate W is supplied with a highly reactive SPM solution in each of Steps S3 and Step S5, and is supplied with a low reactive SPM solution in Step S4 also in the second embodiment. Thus, the non-cured layer Rb can be removed using the low reactive SPM solution while appropriately removing the first cured layer Ra and the second cured layer Rc using the highly reactive SPM solution, similarly to the first embodiment. In addition, since the concentration of sulfuric acid in the SPM solution supplied to the substrate W in Step 4 is high, the SPM solution with this high concentration of sulfuric acid is recovered by the tank 46 in the second embodiment. Thus, the usage of sulfuric acid in Step S4 can further be reduced.

In the aforementioned example, the guard 71 for discarding and the guard 71 for recovery are separately provided. In other words, the guard 71 that receives the SPM solution with a high concentration of sulfuric acid in Step S4 is different from the guard 71 that receives the SPM solution with a low concentration of sulfuric acid in each of Steps S3 and S5. This can suppress contamination of the SPM solution with the low concentration of sulfuric acid into the tank 46.

### <Second example of processing part>

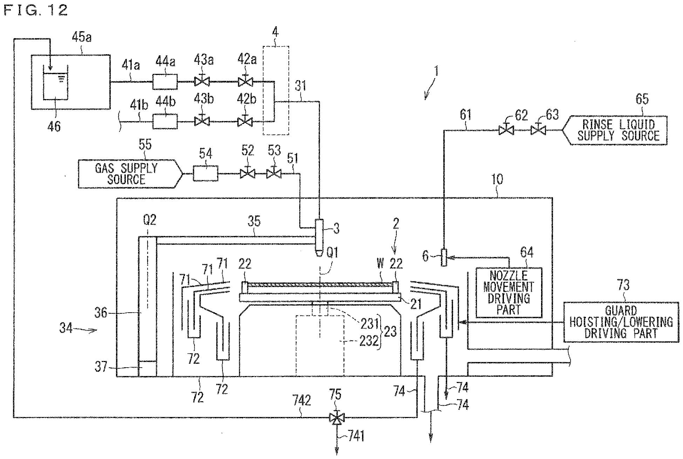

FIG. 12 is a diagram illustrating a second example structure of the processing part 1 according to the second embodiment. In the example of FIG. 12, the downstream end of the pipe 74 corresponding to the inner guard 71 is connected to a switcher 75, and the switcher 75 is connected to an upstream end of a discarding pipe 741 and an upstream end of a recovery pipe 742. A downstream end of the discarding pipe 741 is connected to an external discarding part, and a downstream end of the recovery pipe 742 functions as a supply port to the tank 46. The switcher 75 switches a pipe in communication with the pipe 74 between the discarding pipe 741 and the recovery pipe 742. The switcher 75 is, for example, a cross valve. The controller 90 controls the switcher 75.

While the switcher 75 sets the pipe 74 in communication with the discarding pipe 741, the SPM solution received by the inner guard 71 is discharged to the discarding part through the cup 72 and the pipe 74 which correspond to the inner guard 71 and through the discarding pipe 741. While the switcher 75 sets the pipe 74 in communication with the recovery pipe 742, the SPM solution received by the inner guard 71 is recovered by the tank 46 through the cup 72 and the pipe 74 which correspond to the inner guard 71 and through the recovery pipe 742.

The pipe 74 corresponding to the inner guard 71 which is connected to the switcher 75 is not always limited to this. The pipe 74 corresponding to the outer guard 71 or the middle guard 71 may be connected to the switcher 75. The following will assume that the pipe 74 corresponding to the inner guard 71 is connected to the switcher 75.

Example operations of the substrate processing apparatus 100 are identical to those of FIG. 5. However, the guard hoisting/lowering driving part 73 locates the outer guard 71, the middle guard 71, and the inner guard 71 in the upper positions in all Steps S3 to S5. Furthermore, the processing part 1 supplies, in Step S4 (the second step), the main surface of the substrate W with the SPM solution with a concentration of sulfuric acid higher than those in both Step S3 (the first step) and Step S5 (the third step).

Furthermore, the switcher 75 sets the pipe 74 in communication with the recovery pipe 742 in Step S4. Consequently, after the SPM solution with the higher concentration of sulfuric acid is supplied to the substrate W in Step S4, the SPM solution is recovered by the tank 46 through the inner guard 71, the cup 72, the pipe 74, and the recovery pipe 742. In each of Steps S3 and S5, the switcher 75 sets the pipe 74 in communication with the discarding pipe 741. Thus, after the SPM solution with the lower concentration of sulfuric acid is supplied to the substrate W, the SPM solution is discharged to the discarding part through the inner guard 71, the cup 72, the pipe 74, and the discarding pipe 741.

As described above, since the concentration of sulfuric acid in the SPM solution supplied to the substrate W in Step 4 is high also in the second example of the processing part 1, the SPM solution with this high concentration of sulfuric acid is recovered by the tank 46. Thus, the usage of sulfuric acid in Step S4 can further be reduced.

Although the substrate processing method is described in detail, the description is in all aspects illustrative and does not restrict this disclosure. The various modifications described above may be combined and used unless any contradiction occurs. Therefore, numerous modifications and variations that have not yet been exemplified are devised without departing from the scope of the present disclosure.

Although the processing part 1 executes Step S6 (finishing SPM step) in the aforementioned specific examples, the processing part 1 may omit execution of Step S6. When the processing part 1 does not execute Step S6, the processing part 1 should execute Step S7 (the forcing step) in succession from Step S5 (the third step). Since the first nozzle 3 discharges aqueous hydrogen peroxide in Step S7, the possibility that sulfuric acid remains inside the first nozzle 3 can be reduced.

Although the substrate processing apparatus 100 is a single-wafer processing apparatus in the aforementioned examples, it may be a batch processing apparatus. The substrate processing apparatus 100 may include, for example, a first processing tank in which the SPM solution mixed at a highly reactive mixing ratio is stored, and a second processing tank in which the SPM solution mixed at a low reactive mixing ratio is stored. The substrate processing apparatus 100 may immerse a plurality of substrates W in the SPM solution in the first processing tank to remove the first cured layer Ra, then immerse the plurality of substrates W in the SPM solution in the second processing tank to remove the non-cured layer Rb, and then immerse the plurality of substrates W again in the SPM solution in the first processing tank to remove the second cured layer Rc. The first processing tank need not always store the SPM solution, and a spray nozzle may be disposed inside the first processing tank. The substrate processing apparatus 100 may transport the plurality of substrates W into the first processing tank, and discharge the SPM solution in the form of droplets toward the plurality of substrates W from the spray nozzle.

### EXPLANATION OF REFERENCE SIGNS

31 liquid supply pipe
452 recovery pipe
46 tank
74 recover pipe (pipe)
R organic layer (resist layer)
Ra first cured layer
Rb non-cured layer
Rc second cured layer
S 1 holding step (step)
S3 first step (step)
S4 second step (step)
S5 third step (step)
W substrate

## Claims

1. A substrate processing method for removing an organic layer on a substrate, the organic layer being formed on a main surface of the substrate, the organic layer including a first cured layer, a non-cured layer, and a second cured layer, the method comprising:
a holding step of holding the substrate;
a first step of supplying the main surface of the substrate with a mixed solution of sulfuric acid and aqueous hydrogen peroxide to remove the first cured layer;
a second step of supplying, after the first step, the main surface of the substrate with the mixed solution mixed at a mixing ratio lower reactive than the mixed solution in the first step to remove the non-cured layer; and
a third step of supplying, after the second step, the main surface of the substrate with the mixed solution mixed at a mixing ratio higher reactive than the mixed solution in the second step to remove the second cured layer.

2. The substrate processing method according to claim 1,
wherein the mixed solution is supplied to the main surface of the substrate in the form of droplets in at least one of the first step and the third step, and
the mixed solution is supplied to the main surface of the substrate in the form of a continuous stream in the second step.

3. The substrate processing method according to claim 2, further comprising
a finishing SPM step of supplying, after the third step, the main surface of the substrate with the mixed solution in the form of the continuous stream,
wherein the mixed solution is supplied to the main surface of the substrate in the form of droplets in the third step.

4. The substrate processing method according to any one of claims 1 to 3,
wherein a concentration of the sulfuric acid in the mixed solution in the second step is lower than a concentration of the sulfuric acid in the mixed solution in the first step.

5. The substrate processing method according to any one of claims 1 to 3,
wherein a concentration of the sulfuric acid in the mixed solution in the second step is higher than a concentration of the sulfuric acid in the first step, and
in the second step, the sulfuric acid stored in a tank is supplied to the main surface of the substrate through a liquid supply pipe, and the mixed solution passing through the main surface of the substrate is returned to the tank through a recovery pipe.
